# EUROPÄISCHE PATENTSCHRIFT

(11) **EP 1 401 609 B1**
(45) Veröffentlichungstag und Bekanntmachung des Hinweises auf die Patenterteilung: **26.01.2005**
(21) Anmeldenummer: 02740382.3
(22) Anmeldetag: 27.05.2002
(51) Int. Cl.: B23K 26/04, B23K 26/02, B23K 26/42

(54) **VERFAHREN ZUR KALIBRIERUNG DES OPTISCHEN SYSTEMS EINER LASERMASCHINE ZUR BEARBEITUNG VON ELEKTRISCHEN SCHALTUNGSSUBSTRATEN**
METHOD FOR THE CALIBRATION OF THE OPTICAL SYSTEM ON A LASER MACHINE FOR MACHINING ELECTRICAL CIRCUIT SUBSTRATES
PROCEDE POUR ETALONNER LE SYSTEME OPTIQUE D'UNE MACHINE LASER SERVANT A USINER DES SUBSTRATS DE CIRCUITS ELECTRIQUES

(30) Priorität: 29.06.2001 DE 10131610
(43) Veröffentlichungstag der Anmeldung: 31.03.2004
(73) Patentinhaber: Siemens Aktiengesellschaft, 80506 München (DE)
(72) Erfinder: KILTHAU, Alexander, 76669 Bad Schönborn (DE); KLETTI, André, 69207 Sandhausen (DE); MAYER, Hans, Jürgen, 68519 Viernheim (DE); ROELANTS, Eddy, B-8000 Brügge (BE)
(86) Internationale Anmeldenummer: PCT/DE2002/001950
(87) Internationale Veröffentlichungsnummer: WO 2003/004212

(56) Entgegenhaltungen:
- US-A- 5 832 415

## Beschreibung

Die Erfindung betrifft ein Verfahren zur Kalibrierung des optischen Systems einer Lasermaschine zur Bearbeitung von elektrischen schaltungssubstraten, bei der der Laserstrahl einer Laserquelle über eine Ablenkeinheit und eine Abbildungseinheit auf Zielpunkte einer Bearbeitungsfläche gerichtet wird, wobei die Positionen vom Markierungen auf der Bearbeitungsfläche mit Hilfe einer Kamera erfasst und vermessen werden. US 5 832 415 A offenbart ein solches Verfahren.

Für die Bearbeitung von elektrischen Schaltungssubstraten, zum Beispiel Leiterplatten, werden zunehmend Laser dann eingesetzt, wenn sehr feine Strukturen mit großer Geschwindigkeit bearbeitet werden sollen. Dabei geht es zum Beispiel um das Bohren von Durchgangslöchern oder Sacklöchern zur Durchkontaktierung zwischen verschiedenen Schichten einer Leiterplatte, um die Strukturierung von leitenden oder auch nicht leitenden Schichten, von Lötstopplacken, Ätzresistschichten und dergleichen. Dabei werden beispielsweise Sacklöcher in mehreren Schritten gebohrt, wobei die eigentliche Bearbeitungsebene in unterschiedlicher Höhe zur Brennebene des optischen Systems liegen kann, um beispielsweise unterschiedliche Energiedichten zur Wirkung zu bringen.

Solange der Laserstrahl nur über eine kleine Bearbeitungsfläche abgelenkt wird, läßt sich eine gute Positioniergenauigkeit erzielen, da in diesem Fall nur der mittlere Teil der zur Fokussierung des Laserstrahls notwendigen telezentrischen Linse genutzt wird. Da um die optische Achse des F-Theta-Objektivs die Telezentrie immer gut erfüllt ist, ergeben sich auch keine Probleme, wenn außerhalb der Fokusebene gebohrt oder strukturiert wird.

Zunehmend ergibt sich jedoch der Wunsch, zur Erhöhung der Arbeitsgeschwindigkeit und der Ausbeute mit dem Laserstrahl ein größeres Bearbeitungsfeld zu überdecken, wobei dann auch die Randbereiche der telezentrischen Linse genutzt werden müssen. Da diese Linsen aber einen zum Randbereich hin zunehmenden Winkelfehler besitzen, nehmen die Positionierungsfehler um so mehr zu, je weiter der Strahl von der optischen Achse weg zum Einsatz kommt.

Eine gewisse Verbesserung lässt sich dadurch erzielen, dass man mit der Kamera eine Musterplatte mit genau vorgegebenen Markierungen vermisst, daraus Korrekturwerte ableitet und diese bei der Ansteuerung des Ablenksystems berücksichtigt. Es hat sich jedoch gezeigt, dass solche Korrekturwerte um so weniger zu einer genauen Positionierung ausreichen, je mehr die Bearbeitungsebene außerhalb der Fokusebene liegt.

Ziel der vorliegenden Erfindung ist es, ein Verfahren zur Kalibrierung des optischen Systems einer Lasermaschine zur Bearbeitung von elektrischen Schaltungssubstraten der eingangs genannten Art anzugeben, welches es ermöglicht, mit dem Laser ein möglichst großes Feld zu bearbeiten und dabei den Laserstrahl im gesamten Bearbeitungsfeld und in unterschiedlichen Arbeitshöhen bezüglich der Fokusebene mit höchster Genauigkeit zu positionieren.

Erfindungsgemäß weist ein solches Verfahren folgende Schritte auf:
- eine erste Probeplatte mit einer vorgegebenen Bearbeitungsfläche wird in der Fokusebene der Abbildungseinheit als einer ersten Kalibrierebene angeordnet, danach werden auf dieser Probeplatte vorgegebene Zielpunkte in einem die Bearbeitungsfläche bedeckenden Raster mit dem Laserstrahl angesteuert und mit Markierungen versehen,
- die Positionen der Markierungen der ersten Probeplatte werden mit Hilfe der Kamera vermessen und mit den Positionen der vorgegebenen Zielpunkte verglichen, wobei aus den Abweichungen jeweils erste Korrekturwerte in einer ersten Korrekturtabelle gespeichert werden;
- eine zweite Probeplatte mit der vorgegebenen Bearbeitungsfläche wird in einer zweiten Kalibrierebene parallel und in einem vorgegebenen Abstand zur Fokusebene angeordnet, danach werden auf dieser zweiten Probeplatte ebenfalls die Zielpunkte in denselben Raster wie bei der ersten Probeplatte mit dem Laserstrahl angesteuert und mit Markierungen versehen,
- die Positionen der Markierungen der zweiten Probeplatte werden ebenfalls vermessen und mit den Positionen der vorgegebenen Zielpunkte verglichen, wobei aus den Abweichungen jeweils zweite Korrekturwerte in einer zweiten Korrekturtabelle gespeichert werden, und
- die Korrekturwerte aus der ersten und der zweiten Korrekturtabelle werden einer Steuereinheit zugeführt, welche nach Bedarf für jeden Zielpunkt in jeder beliebigen zwischen der Fokusebene und der zweiten Kalibrierebene liegenden Bearbeitungsebene jeweils aktuelle Korrekturwerte durch Interpolation aus den ersten und den zweiten Korrekturwerten ermittelt und für die Ansteuerung der Ablenkeinheit zur Verfügung stellt.

Bei dem erfindungsgemäßen Verfahren wird also eine Kalibrierung in mindestens zwei unterschiedlichen Ebenen, nämlich in den beiden Extrempositionen für die Bearbeitungsebene, vorgenommen. Dabei werden die Kissen- Tonnen- Verzeichnungen sowie die Winkelfehler der telezentrischen Linse in den beiden Ebenen ermittelt und praktisch in eine dreidimensionale Korrekturtabelle umgewandelt. Auf diese Weise wird nicht nur in den beiden zur Kalibrierung vermessenen Ebenen eine horizontale Interpolation der Korekturwerte möglich, sondern es können auch beliebige dazwischenliegende Bearbeitungshöhen interpoliert werden. Damit kann auch außerhalb der Fokusebene ein großes Schreibfeld, zum Beispiel 50 mm X 50 mm, genutzt werden, wobei der Geschwindigkeitsvorteil einhergeht mit einer gleichbleibenden Genauigkeit beim Bearbeiten.

In einer vorteilhaften Ausgestaltung der Laserbohrmaschine ist in bekannter Weise vorgesehen, dass der Strahlengang der Kamera über den gleichen optischen Pfad wie der Laserstrahl geführt wird. In diesem Fall kann ein zusätzlicher optischer Fehler dadurch entstehen, dass die Beleuchtung für das Kamerabild eine andere Wellenlänge aufweist, als der Laserstrahl. In diesem Fall ist in einer Weiterbildung der Erfindung vorgesehen, dass vor der Bestrahlung der ersten Probeplatte eine Musterplatte (Mapping-Platte) mit den vorgegebenen Zielpunkten entsprechenden, hochgenau markierten Rasterpunkten in der Fokusebene angeordnet wird, dass dann die Positionen der Rasterpunkte mit Hilfe der Kamera vermessen werden und dass die Abweichungen der gemessenen Positionen von den vorgegebenen Positionen der Rasterpunkte in einer Kamera-Korrekturtabelle niedergelegt und bei der Ermittlung der Korrekturwerte für die Ansteuerung der Ablenkeinheit berücksichtigt werden.

Für besondere Fälle kann es auch erwünscht sein, die Bearbeitungsebene nicht nur nach einer Seite der Fokusebene, sondern auch nach der anderen Seite der Fokusebene zu verlegen. Für diesen Fall sind in einer Weiterbildung folgende Zusatzschritte vorgesehen:
- Eine dritte Probeplatte mit der vorgegebenen Bearbeitungsfläche wird in einer dritten Kalibrierebene parallel zur Fokusebene und in einem vorgegebenen Abstand zu dieser, jedoch der zweiten Kalibrierebene bezüglich der Fokusebene gegenüberliegend, angeordnet,
- danach werden auf dieser Probeplatte ebenfalls die Zielpunkte in dem selben Raster wie bei der ersten und der zweiten Probeplatte mit dem Laserstrahl angesteuert und mit Markierungen versehen,
- die Positionen der Markierungen der dritten Probeplatte werden mit Hilfe der Kamera vermessen und mit den Positionen der vorgegebenen Zielpunkte verglichen, wobei aus den Abweichungen jeweils dritte Korrekturwerte gewonnen und in einer dritten Korrekturtabelle gespeichert werden, und
- die Korrekturwerte aus der ersten und der dritten Korrekturtabelle werden der Steuereinheit zugeführt, welche nach Bedarf für jeden Zielpunkt in einer beliebigen zwischen der Fokusebene und der dritten Kalibrierebene liegenden Bearbeitungsebene Korrekturwerte durch Interpolation aus den ersten und den dritten Korrekturwerten ermittelt und für die Ansteuerung der Ablenkeinheit zur Verfügung stellt.

In weiterer Ausgestaltung ist es auch möglich, bei Bedarf über den Bereich der für die Kalibrierung verwendeten zweiten und gegebenenfalls dritten Kalibrierebene hinaus eine Bearbeitungsebene zu verwenden, wobei dann die Korrekturwerte aus der ersten und der zweiten bzw. dritten Korrekturtabelle auch verwendet werden, um für Zielpunkte außerhalb des durch die Fokusebene und die zweite bzw. dritte Kalibrierebene gegebenen Bereiches Korrekturwerte durch Extrapolation zu ermitteln.

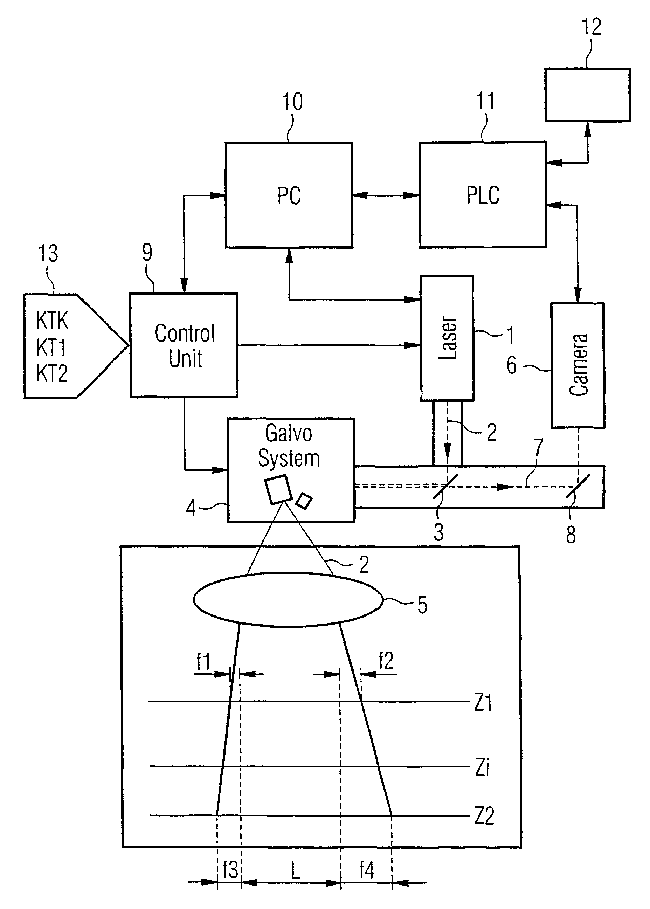

Die Erfindung wird nachfolgend an einem Ausführungsbeispiel anhand der Zeichnung näher erläutert.

Die einzige Figur zeigt eine schematische Darstellung der verschiedenen Kalibrierebenen in Verbindung mit einem Blockschaltbild der Laserbearbeitungsanordnung.

Die Figur zeigt in Blockdarstellung die wesentlichen Teile einer Laserbearbeitungsmaschine. Kernstück ist eine Laserquelle, deren Laserstrahl 2 über einen dichroitischen Spiegel 3 abgelenkt und einer Galvanometerspiegel-Ablenkeinheit 4 zugeführt wird. Diese besitzt zwei,um zueinander senkrechte Achsen bewegliche Spiegel, mit denen der Strahl an jeden Punkt eines Bearbeitungsfeldes gelenkt werden kann. Zur Fokussierung ist zwischen das Ablenksystem 4 und das eigentliche Bearbeitungsfeld eine telezentrische Linse 5 geschaltet, die den Strahl in die gewünschte Ebene fokussiert. Die Fokusebene ist in vorliegendem Beispiel mit Z1 bezeichnet. Idealerweise würde dabei ein Feld mit der Seitenlänge L überstrichen. Da aber die Linse 5 zu ihrem Randbereich hin zunehmend Ablenkungsfehler aufweist und außerdem auch das Ablenksystem 4 fehlerbehaftet ist, wird das tatsächlich vom Laserstrahl erreichte Feld etwa kissenförmig bzw. tonnenförmig deformiert, so dass beispielsweise über die Seitenlänge L hinaus Ablenkungsfehler f1 und f2 in den Randbereichen des Bearbeitungsfeldes in der Fokusebene Z1, aber noch größere Ablenkungsfehler f3 und f4 in den Randbereichen der Bearbeitungsfläche in einer von der Fokusebene entfernten Bearbeitungsebene Z2 auftreten. Diese Abweichungen sind in der Regel auch nicht symmetrisch, sondern nach allen Seiten unterschiedlich groß.

Die Bearbeitungsfläche wird über eine Kamera 6 vermessen, welche einen Lichtstrahl 7 über den optischen Weg des Laserstrahls, nämlich über die Linse 5 und die Ablenkeinheit 4 sowie über den dichroitischen Spiegel 3 erhält. Über einen weiteren Spiegel 8 wird dieser Strahl 7 in die Kamera geführt. Zur Steuerung der Laserquelle 1 und der Ablenkeinheit 4 dient eine Steuereinheit 9, die in der Regel Teil eines Computers 10 ist. Außerdem ist eine speicherprogrammierbare Steuerung 11 vorgesehen, die sowohl die Kamera als auch die für die Bewegung der Bearbeitungsfläche dienenden Roboter 12 steuert.

Zur Kalibrierung des Systems wird zunächst über der Fokusebene Z1 eine Musterplatte angeordnet, auf der ein die gesamte Bearbeitungsfläche umfassendes Raster von hochgenau angeordneten Markierungspunkten aufgezeichnet ist. Diese Rasterpunkte werden mittels einer nicht dargestellten Beleuchtungsvorrichtung, welche beispielsweise Leuchtdioden einer Wellenlänge von 800 nm enthält, beleuchtet und mit Hilfe der Kamera vermessen. Die gewonnenen Koordinaten jedes einzelnen Markierungspunktes werden mit deren bekannten Positionswerten verglichen; Abweichungen werden in eine Kamera-Korrekturtabelle KTK, vorzugsweise in einem Speicher 13 des Computers 10, gespeichert.

In dem ersten eigentlichen Kalibrierungsschritt für die Ablenkung des Laserstrahls wird nunmehr eine erste Probeplatte in der Fokusebene Z1 angeordnet. Dabei handelt es sich beispielsweise um eine mit einer weißen Lackschicht versehene Glasplatte. Auf dieser ersten Probeplatte werden nun alle Rasterpunkte des vorgegebenen Bearbeitungsfeldes als Zielpunkte mit dem Laserstrahl angesteuert und markiert, beispielsweise indem mit dem Laserstrahl ein Kreuz eingebrannt wird. Diese Markierungen werden anschließend mit der Kamera 6 abgetastet und vermessen, wobei die gemessenen Koordinaten mit den Zielkoordinaten der einzelnen Rasterpunkte verglichen werden. Die Abweichungen werden in Form von Korrekturwerten in eine erste Korrekturtabelle KT1 in den Speicher 13 eingegeben.

In einem weiteren Kalibrierschritt wird nun wiederum eine leere zweite Probeplatte in einer zweiten Bearbeitungsebene Z2 angeordnet, welche um einen vorgegebenen Betrag von der Fokusebene Z1 entfernt wird. Wie beim vorhergehenden Kalibrierungsschritt wird auch diesmal jeder Rasterpunkt des Bearbeitungsfeldes mit dem Laserstrahl angesteuert und in Form einer Markierung eingebrannt. Danach werden wieder alle Markierungen durch die Kamera 6 abgetastet und vermessen; die Abweichungen von den Positionsdaten der Zielpunkte werden als zweite Korrekturwerte in eine zweite Korrekturtabelle KT2 in den Speicher 13 gegeben.

Mit den so gewonnenen und gespeicherten Korrekturwerten kann nun für jeden Zielpunkt einer beliebigen Ebene Zi im Raumbereich zwischen der Fokusebene Z1 und der zweiten Kalibrierebene Z2 ein Korrekturwert durch Interpolation aus den beiden Korrekturtabellen KT1 und KT2 abgeleitet werden. Damit können beispielsweise Bohrungen mit einer Genauigkeit von ± 5 µm positioniert werden.

## Patentansprüche

1. Verfahren zur Kalibrierung des optischen Systems einer Lasermaschine zur Bearbeitung von elektrischen Schaltungssubstraten, wobei der Laserstrahl (2) einer Laserquelle (1) über eine Ablenkeinheit (4 und eine Abbildungseinheit (5) auf Zielpunkte einer Bearbeitungsfläche gerichtet wird und wobei die Positionen von Markierungen auf der Bearbeitungsfläche mit Hilfe einer Kamera (6) erfasst und vermessen werden, mit folgenden kennzeichnenden Schritten:
- Eine erste Probeplatte mit einer vorgegebenen Bearbeitungsfläche wird in der Fokusebene (Z1) der Abbildungseinheit in einer ersten Kalibrierebene angeordnet,
- danach werden auf diese Probeplatte vorgegebene Zielpunkte in einem die Bearbeitungsfläche umfassenden Raster mit dem Laserstrahl (2) angesteuert und mit Markierungen versehen,
- die Positionen der Markierungen der ersten Probeplatte werden mit Hilfe der Kamera (6) vermessen und mit den Positionen der vorgegebene Zielpunkte verglichen, wobei aus den Abweichungen jeweils erste Korekturwerte in einer ersten Korrekturtabelle (KT1) gespeichert werden,
- eine zweite Probeplatte mit der vorgegebenen Bearbeitungsfläche wird in einer zweiten Kalibrierebene (Z2) parallel und in einem vorgegebenen Abstand zur Fokusebene (Z1) angeordnet, danach werden auf dieser zweiten Probeplatte ebenfalls die Zielpunkte in dem selben Raster wie bei der ersten Probeplatte mit dem Laserstrahl (2) angesteuert und mit Markierungen versehen,
- die Positionen der Markierungen der zweiten Probeplatte werden ebenfalls vermessen und mit den Positionen der vorgegebenen Zielpunkte verglichen, wobei aus den Abweichungen jeweils zweite Korrekturwerte ermittelt und in einer zweiten Korrekturtabelle (KT2) gespeichert werden, und
- die Korrekturwerte aus der ersten und der zweiten Korrekturtabelle (KT1, KT2) werden einer Steuereinheit (9) zugeführt, welche nach Bedarf für jeden Zielpunkt in jeder beliebigen zwischen der Fokusebene (Z1) und der zweiten Kalibrierebene (Z2) liegenden Bearbeitungsebene (Z3) Korrekturwerte durch Interpolation aus den ersten und den zweiten Korrekturwerten ermittelt und für die Ansteuerung der Ablenkeinheit (4) zur Verfügung stellt.

2. Verfahren nach Anspruch 1, wobei der Strahlengang der Kamera (6) über den gleichen optischen Pfad wie der Laserstrahl (2) geführt wird, mit folgenden zusätzlichen Schritten:
- Vor der Bestrahlung der ersten Probeplatte wird eine Musterplatte (Mapping-Platte) mit den vorgegebenen Zielpunkten entsprechenden, hochgenau markierten Rasterpunkten in der Fokusebene (Z1) angeordnet und die Positionen der Rasterpunkte werden mit Hilfe der Kamera (6) vermessen, wobei die Abweichungen der gemessenen Positionen von den vorgegebenen Positionen der Rasterpunkte in einer Kamera-Korrekturtabelle (KTK)niedergelegt und bei der Ermittlung der Korekturwerte für die Ansteuerung der Ablenkeinheit herangezogen wird.

3. Verfahren nach Anspruch 1 oder 2 mit folgenden Zusatzschritten:
- Eine dritte Probeplatte mit der vorgegebenen Bearbeitungsfläche wird in einer dritten Kalibrierebene parallel zur Fokusebene (Z1) und in einem vorgegebenen Abstand zu dieser, jedoch der zweiten Kalibrierebene (Z2) bezüglich der Fokusebene (Z1) gegenüberliegend, angeordnet,
- danach werden auf dieser Probeplatte ebenfalls die Zielpunkte in dem selben Raster wie bei der ersten und bei der zweiten Probeplatte mit dem Laserstrahl angesteuert und mit Markierungen versehen,
- die Positionen der Markierungen der dritten Probeplatte werden mit Hilfe der Kamera vermessen und mit den Positionen der vorgegebenen Zielpunkte verglichen, wobei aus den Abweichungen jeweils dritte Korrekturwerte gewonnen und in einer dritten Korrekturtabelle gespeichert werden und
- die Korrekturwerte aus der ersten und der dritten Korrekturtabelle werden der Steuereinheit (9) zugeführt, welche nach Bedarf für jeden Zielpunkt in jeder beliebigen zwischen der Fokusebene und der dritten Kalibrierebene liegenden Bearbeitungsebene Korrekturwerte durch Interpolation aus den ersten und den dritten Korrekturwerten ermittelt und für die Ansteuerung der Ablenkeinheit (4) zur Verfügung stellt.

4. Verfahren nach einem der Ansprüche 1 bis 3 mit folgendem zusätzlichen Schritt:
- Die Korrekturwerte der ersten und der zweiten bzw. dritten Korrekturtabelle werden verwendet, um für Zielpunkte außerhalb des durch die Fokusebene und die zweite bzw. dritte Kalibrierebene gegebenen Bereiches Korrekturwerte durch Extrapolation zu ermitteln.

## Claims

1. Method of calibrating the optical system of a laser machine for processing electrical circuit substrates, the laser beam (2) of a laser source (1) being directed at target points of a processing surface by means of a deflecting unit (4) and an imaging unit (5) and the positions of markings on the processing surface being registered and measured with the aid of a camera (6), with the following characterizing steps:
- a first sample plate with a prescribed processing surface is arranged in the focal plane (Z1) of the imaging unit in a first calibrating plane,
- after that target points prescribed on this sample plate are targeted with the laser beam (2) in a grid covering the processing surface and are provided with markings,
- the positions of the markings of the first sample plate are measured with the aid of the camera (6) and compared with the positions of the prescribed target points, first correction values from the deviations being stored in each case in a first correction table (KT1);
- a second sample plate with the prescribed processing surface is arranged in a second calibrating plane (Z2) parallel to and at a prescribed distance from the focal plane (Z1), after that the target points on this second sample plate are likewise targeted with the laser beam (2) in the same grid as in the case of the first sample plate and provided with markings,
- the positions of the markings of the second sample plate are likewise measured and compared with the positions of the prescribed target points, second correction values being determined from the deviations and stored in each case in a second correction table (KT2), and
- the correction values from the first correction table (KT1) and the second correction table (KT2) are fed to a control unit (9), which determines as required for each target point in each arbitrary processing plane (Z3) lying between the focal plane (Z1) and the second calibrating plane (Z2) correction values by interpolation from the first correction values and the second correction values and makes them available for the activation of the deflecting unit (4).

2. Method according to Claim 1, the beam of the camera (6) being directed over the same optical path as the laser beam (2) and with the following additional steps:
- before the irradiation of the first sample plate, a pattern plate (mapping plate) with the prescribed target points of corresponding, highly accurately marked grid points is arranged in the focal plane (Z1) and the positions of the grid points are measured with the aid of the camera (6), the deviations of the measured positions from the prescribed positions of the grid points are stored in a camera correction table (KTK) and used during the determination of the correction values for the activation of the deflecting unit.

3. Method according to Claim 1 or 2, with the following additional steps:
- a third sample plate with the prescribed processing surface is arranged in a third calibrating plane, parallel to the focal plane (Z1) and at a prescribed distance from it, but lying opposite from the second calibrating plane (Z2) with respect to the focal plane (Z1),
- after that, the target points on this sample plate are likewise targeted with the laser beam in the same grid as in the case of the first sample plate and the second sample plate and provided with markings,
- the positions of the markings of the third sample plate are measured with the aid of the camera and compared with the positions of the prescribed target points, third correction values being obtained from the deviations and stored in each case in a third correction table, and
- the correction values from the first correction table and the third correction table are fed to the control unit (9), which determines as required for each target point in each arbitrary processing plane lying between the focal plane and the third calibrating plane correction values by interpolation from the first correction values and the third correction values and makes them available for the activation of the deflecting unit (4).

4. Method according to one of Claims 1 to 3, with the following additional step:
- the correction values of the first correction table and the second and/or third correction tables are used to determine correction values by extrapolation for target points outside the region given by the focal plane and the second and/or third calibrating plane.

## Revendications

1. Procédé pour étalonner le système optique d'une machine laser servant à usiner des substrats de circuits électriques, le rayon laser (2) d'une source laser (1) étant dirigé sur des points de mire d'une surface à usiner au moyen d'une unité de déflexion (4) et d'une unité de représentation (5) et les positions de repères sur la surface à usiner étant enregistrées et mesurées à l'aide d'une caméra (6), comprenant les étapes caractérisantes suivantes :
- Une première plaque de prélèvement d'éprouvettes avec une surface à usiner prédéfinie et disposée dans le plan focal (Z1) de l'unité de représentation dans un premier plan d'étalonnage,
- des points de mire prédéfinis sur cette plaque de prélèvement d'éprouvettes sont ensuite visés par le rayon laser (2) dans une grille couvrant la surface à usiner et pourvus de repères
- les positions des repères de la première plaque de prélèvement d'éprouvettes sont mesurées à l'aide de la caméra (6) et comparées aux positions des points de mire prédéfinis, à chaque fois des premières valeurs de correction provenant des écarts étant mémorisées dans une première table de correction (KT1),
- une seconde plaque de prélèvement d'éprouvettes avec la surface à usiner prédéfinie est disposée dans un second plan d'étalonnage (Z2) parallèlement et à une distance donnée du plan focal (Z1), sur cette deuxième plaque de prélèvement d'éprouvettes les points de mire sont également visés et pourvus de repères dans la même grille par le rayon laser (2) comme pour la première plaque de prélèvement d'éprouvettes,
- les positions des repères de la seconde plaque de prélèvement d'éprouvettes sont également mesurées et comparées aux positions des points de mire prédéfinis, de secondes valeurs correctrices étant calculées à partir des écarts et mémorisées dans une seconde table de correction (KT2) et
- les valeurs correctrices provenant de la première et de la seconde table de correction (KT1, KT2) sont transmises à une unité de commande (9) qui calcule des valeurs correctrices par interpolation à partir des premières et des secondes valeurs correctrices selon les besoins pour chaque point de mire dans n'importe quel plan d'usinage se trouvant entre le plan focal (Z1) et le second plan d'étalonnage (Z2) et les met à disposition pour l'activation de l'unité de déflexion (4).

2. Procédé selon la revendication 1, la trajectoire du faisceau de la caméra (6) étant conduite sur la même voie optique que le rayon laser, comprenant les étapes supplémentaires suivantes :
- avant l'irradiation de la première plaque de prélèvement d'éprouvettes, une plaque de projection comportant les points de grille repérés de manière très précise et correspondant aux points de mire prédéfinis est placée dans le plan focal (Z1) et les positions des points de grille sont mesurées à l'aide de la caméra (6), les écarts entre les positions mesurées et les positions prédéfinies des points de grille étant déposées dans une table de correction de la caméra (KTK) et sont utilisées pour calculer les valeurs correctrices servant à activer l'unité de déflexion.

3. Procédé selon la revendication 1 ou 2 comportant les étapes supplémentaires suivantes :
- une troisième plaque de prélèvement d'éprouvettes avec la surface à usiner prédéfinie est disposée dans un troisième plan d'étalonnage parallèlement au plan focal (Z1) et à une distance donnée de celui-ci, en face cependant du second plan d'étalonnage (Z2) par rapport au plan focal (Z1),
- les points de mire sur cette plaque de prélèvement d'éprouvettes sont également visés par le rayon laser dans la même grille que pour la première et la seconde plaque de prélèvement d'éprouvette et pourvus de repères.
- Les positions des repères de la troisième plaque de prélèvement d'éprouvettes sont mesurées à l'aide de la caméra et comparées aux positions des points de mire prédéfinis, des troisièmes valeurs correctrices étant obtenues à chaque fois à partir des écarts et mémorisées dans une troisième table de correction et
- les valeurs correctrices provenant de la première et de la troisième table de correction sont transmises à l'unité de commande (9), qui calcule par interpolation des valeurs correctrices à partir des premières et des troisièmes valeurs correctrices au besoin pour chaque point de mire dans n'importe quel plan d'usinage se trouvant entre le plan focal et le troisième plan d'étalonnage, et les met à disposition pour activer l'unité de déflexion (4)

4. Procédé selon l'une des revendications 1 à 3 comportant l'étape supplémentaire suivante :
- les valeurs correctrices de la première et de la deuxième resp. troisième table de correction sont utilisées pour calculer des valeurs correctrices par extrapolation pour des points de mire se trouvant à l'extérieur de la zone décrite par le plan focal et le deuxième resp. troisième plan d'étalonnage.
